Europäisches Patentamt

European Patent Office

Office européen des brevets

(19)

(11) Publication number : **0 473 373 A2**

(12) **EUROPEAN PATENT APPLICATION**

(21) Application number : **91307764.0**

(22) Date of filing : **23.08.91**

(51) Int. Cl.$^5$ : **H04B 1/30**

(30) Priority : **24.08.90 US 572915**

(43) Date of publication of application :
**04.03.92 Bulletin 92/10**

(84) Designated Contracting States :
**DE FR GB**

(71) Applicant : **ROCKWELL INTERNATIONAL
CORPORATION
400 Collins Road NE, Mail Station 175-100
Cedar Rapids, Iowa 52498 (US)**

(72) Inventor : **Loper, Roger K.
101 Larick Ct.
Marion, Iowa 52302 (US)**

(74) Representative : **Jackson, David Spence et al
REDDIE & GROSE 16, Theobalds Road
London, WC1X 8PL (GB)**

(54) Calibration system for direct conversion receiver.

(57)   A calibration system for use in a direct conversion receiver having a plurality of single channels which is operative for detecting and correcting for gain, DC offset and phase errors associated with the signal channels. The present invention provides a built-in test function which may be used on a discontinuance basis to calibrate the receiver so as to correct for the inevitable variation between the amplifiers, filters and other equipment which make up the signal channels in the receiver and result in hardware-induced errors in the baseband components produced on these channels and distortion in the output of the receiver.

   The calibration system includes a system generator for providing a calibration signal, a control unit for regulating the overall operation of the system, a synthesizer for use in providing injection signals to the mixer in the receiver and a signal processing unit for use in determining errors and implementing appropriate corrections. The calibration system may utilize the receiver's regular synthesizer and signal processing unit by adapting their functions for calibration purposes.

FIG. 2

EP 0 473 373 A2

## BACKGROUND OF THE INVENTION

The present invention relates to radio communications technology and more particularly to direct conversion radio receivers.

At the present time the vast majority of radio receivers are of the superheterodyne type employing one or mote intermediate frequency stages which allow for filtering and amplification at fixed frequencies. Alternatives have always existed to the superheterodyne architecture such as superregenerative and direct conversion designs. However, these alternative designs have unfortunately been subject to serious flaws which have relegated radio receivers of these types to specialty roles within the radio communications world.

Despite the widespread adoption of the superheterodyne design, it has been widely recognized that the direct conversion architecture holds great promise for superior performance. For example, direct conversion receivers are not subject to image rejection problems and are not affected by cross-over spurious responses which are so often the cause of interference and related design difficulties in superheterodyne receivers. Further, direct conversion receivers feature simpler low pass type filters operating at audio frequencies in contrast to the often bulky and expensive bandpass filters employed in superheterodyne receivers, require only a single injection signal at one frequency rather than multiple signals at different frequencies (multiple conversion sets), and provide a good potential for VLSI implementations since a majority of the receiver components consist of active audio and digital circuitry.

Referring now to Fig, 1, a prior art direct conversion receiver 10 would typically include an RF amplifier 2 and a splitter 4 for dividing an incoming RF communications signal into a pair of equal and inphase components. These RF components are mixed at the mixers 6 and 8 with separate injection signals on frequency with the communications signal but separated by 90° in phase, Inphase and quadrature baseband components are thereby formed which are independently filtered and amplified at audio frequencies on a pair of separate signal channels by separate filters 5 and 7 and amplifiers 9 and 11. The baseband inphase and quadrature components formed as a result of the mixing process allow the signal to be conveniently and accurately demodulated upon being supplied to a suitable signal processing unit 12.

This architecture works well except that variations between the signal channels which commonly occur as a result of changes in temperature, frequency and other operational parameters result in gain and phase mismatches as well as DC offsets which produce distortion products in the output of the receiver. Gain mismatches of as little as 0.2 dB and phase mismatches of as little as 1° can result in 40 dB distortion products. Phase mismatches are especially difficult to regulate and constitute a major design problem inherent in this architecture. The resulting distortion products can not ordinarily be reduced to less than 30-40 dB in practice and correspond to discrete tones which greatly limit the performance of the receiver.

Researchers investigating the design of direct conversion radio receivers have frequently recognized on this limitation and a number of systems for correcting for errors between quadrature signal channels have been proposed. However, these systems have in general been specialized designs limited to the processing of signals of only a single modulation type. For example, U.S. Patent 4,926,433 to Werner Reich entitled "Correction Circuit For A Digital Quadrature-Signal Pair" describes a correction system including an error-detecting stage for deriving amplitude, offset and phase errors from which correction signals are formed. However, error detection is limited to wideband FM signals characterized by quadrature signal pairs capable of forming an "elliptical locus" from which the errors can be determined by comparison with an ideal circle. In contrast, AM signals would result in such a locus taking on irregular shapes from which proper error signals could not be derived.

It is, therefore, an object of the present invention to provide a direct conversion receiver which is chatacterized by superior performance due to the absence of distortion products arising from gain and phase errors between the signal channels and DC offset errors.

It is another object of the present invention to provide a calibration system for a direct conversion receiver which is adapted for processing signals of all major modulation types, (i.e. AM, FM, SSB, PSK etc.) and correcting phase and gain errors between the signal channels and DC offsets within the receiver pursuant to simple signal processing algorithms.

It is a yet further object of the present invention to provide a new system for calibrating the signal channels of a direct conversion radio receiver which is economic to construct, provides superior performance and may be substantially implemented in VLSI.

## SUMMARY

The present invention constitutes a calibration system for use in a direct conversion receiver having a plurality of signal channels which is operative for detecting and correcting for gain, DC offset and phase errors associated with the signal channels. The present invention provides a built-in-test function which may be used on a discontinuous basis to calibrate the receiver to correct for the inevitable variations between the amplifiers, filters and other equipment which make up these signal channels and result in hardware-induced errors in the baseband components and distortion in the output of the receiver.

The present invention comprises a calibration system including a signal generator for providing a calibration signal, a control unit for regulating the overall operation of the system, a synthesizer for use in providing injection signals to the mixers in the receiver and a,signal processing unit for use in determining errors and implementing appropriate corrections. The calibration system utilizes the receiver's "regular" synthesizer and signal processing unit by adapting their functions for calibration purposes. In the wideband receiver of the preferred embodiment, the signal genetator comprises a comb generator for supplying a set of narrowband calibration signals spaced-apart across a wide frequency range. The control unit comprises a microprocessor controller and associated hardware for switching the input to the receiver, for identifying a comb line calibration signal in proximity to one or more communications signals to be processed by the receiver and for tuning the injection signals provided by the synthesizer to a suitable frequency for producing baseband tones of the signal channels of the receiver as the injection signals are mixed with the calibration signal. The control unit regulates the receiver input, synthesizer and signal processing unit to configure the same for a short duration test during which the channels of the receiver can be accurately calibrated.

During the test interval, the signal processing unit calculates the gain, DC offset and phase errors between and on the signal channels during the test interval by comparing the amplitudes of the baseband tones on the signal channels determining the DC levels of the signals on both of the channels and comparing the phases of the baseband tones on the separate signal channels, The signal processing unit then implements correction functions which during normal receiver operations automatically adjust the baseband components on an ongoing basis as a function of the gain, DC offset and phase errors so detected. A receiver direct conversion is thereby provided having an output which is substantially free of distortion due to hardware-induced errors between the baseband components independently processed on the separate signals channels of the receiver.

## BRIEF DESCRIPTION OF THE DRAWINGS

Figure 1 provides an overall high level block diagram of a prior art type I/Q channel direct conversion receiver depicting the basic architecture of such receivers.

Figure 2 provides an overall high level block diagram of a I/Q channel direct conversion receiver including a calibration system in accordance with the principles of the present invention.

Figure 3 provides a high level flow chart illustrating the operation of the calibration system of the present invention when the receiver is in calibration mode.

Figure 4 is a flow chart illustrating the signal processing routines executed by the signal processing unit of the receiver of the present invention when in the calibration mode.

Figure 5 is a flow chart illustrating the signal processing subroutines used in accurately determining the actual voltage peaks of the baseband tones on the signal channels of the receiver of the present invention.

Figure 6 is a flow chart illustrating the signal processing subroutines used in accurately determining the zero voltage crossing points of the baseband tones on the signal channels of the receiver of the present invention.

## DESCRIPTION OF THE PREFERRED EMBODIMENT

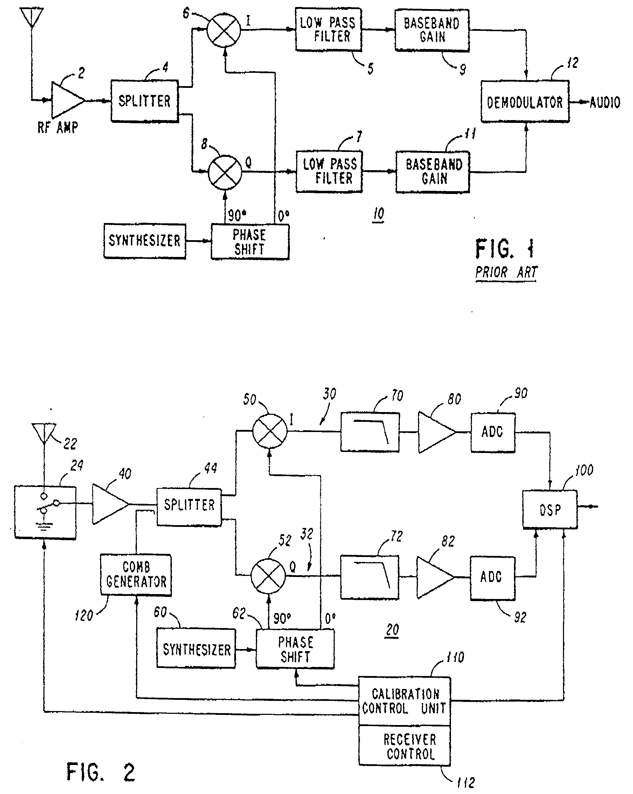

Referring now to Figure 2, the basic structure is shown for a direct conversion (zero If) radio receiver 20 constructed in accordance with the principles of the present invention. The receiver 20 is adapted for selecting among radio frequency ("RF") communications signals provided by the antenna 22 and amplifying a selected signal to power levels suitable for audio output. The radio receiver 20 is characterized by a pair of I and Q channels 30 and 32 along which in quadrature signals are processed by the receiver 20.

During normal (non-calibration mode) operations RF communications signals provided by the antenna 22 are directed through the switch 24 to an RF amplification stage 40 which elevates their power levels and provides some gain outside audio frequencies. The RF amplification stage 40 may be associated with an RF preselector (not shown) providing some coarse RF filtering action useful in rejecting far-off channel signals. The RF communication signals are supplied from the RF amplification stage 40 to the splitter 44 which divides the RF signal into two equal amplitude and in-phase components for processing on the channels 30 and 32 comprising the main section of the receiver 20. The RF components provided by the splitter 44 are directed to the mixers 50 and 52 where they are mixed with separate injection signals. The injection signals have identically the same frequency but are in quadrature (i.e. 90° out-of-phase) with one another. The injection signals are generated by a frequency synthesizer 60 which produces a single injection signal at (or as neat to as possible) the particular communications signal being tuned by the receiver and by the phase shifting network 62 which splits the injection signal into equal but 90° out-of-phase components, since the injection signals are "on-frequency" with the original RF communications signal, a pair of baseband signal components are produced as a result of the mixing process which are supplied down the I and Q channels 30 and 32 to the lowpass filter networks 70 and 72 which are operative for providing the required selectivity for the receiver 20 and are supplied to the baseband audio amplification stages 80 and 82 which function to furnish most of the gain for the receiver 20.

The signals on the channels 30 and 32 and output from the amplification stages 80 and 82 are in turn supplied to the analog-to-digital converters ("ADCs") 90 and 92 which translate the signals from analog to digital formats. The digital signals generated by the ADCs 90 and 92 are directed to the digital processing unit 100 which is adapted for correcting for hardware-induced errors between the baseband components processed on the I and Q signal channels 30 and 32 demodulating the signal components in accordance with well known techniques in order to acquire the information carried by the original RF communications signal being tuned by the receiver 20.

The digital signal processing unit 100 automatically adjusts the baseband components from the channels 30 and 32 during signal processing to correct for hardware-induced errors based on the operation of the calibration system of the present invention. The calibration system includes the calibration control unit 110 (associated with the overall receiver control system 112), a comb signal generator 120, the switch 24, the receiver's regular synthesizer 60 and selected calibration algorithms within the digital signal processing unit 100. The calibration system is used on a discontinuous basis and may be activated whenever the receiver 20 is turned on, whenever the frequency of the communications signals being processed change or periodically during the operation of the receiver 20.

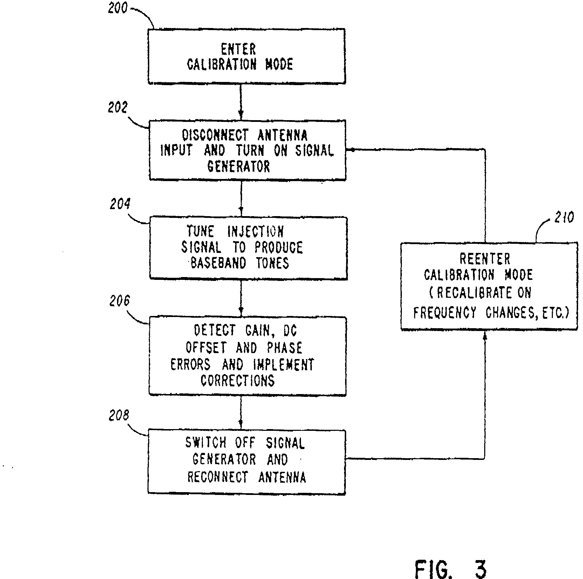

Referring now to Figure 3, when the receiver's calibration mode is engaged as indicated in step 200, the calibration unit 110 controls the switch 24 to connect the input of the amplification stage 40 to ground (as shown) and turn on the comb signal generator 120 which is coupled to the input to the splitter 44 as shown in step 202. The synthetizer 60 is then regulated by the calibration control unit 110 in accordance with step 204 to tune the injection signals provided to the phase shift network 62 to a frequency spaced 2500 Hz apart from the comb line signal provided by the comb generator 120 which is nearest in frequency to the communications signal or signals intended to be processed by the receiver 20. When the signals from the phase shift network 62 ate mixed with the comb line, signal from the comb generator 120 in the mixers 50 and 52, baseband tones of fixed amplitude, frequency and phase are thereby produced on the signal channels 30 and 32 which are in quadrature to the greatest extent practicable. These baseband tones are processed by the filters and amplifiers comprising the hardware installed on the signal channels 30 and 32 and are converted to digital format by the ADCs 90 and 92 prior to being supplied to the digital processing unit 100. The baseband tones allow for the hardware-induced gain, DC offset and phase errors inherent in the signal channels 30 and 32 to be rapidly detected by calibration-algorithms in the signal processing unit 100 engaged by the control unit 110 and for adjustments to be implemented in the processing functions of the digital signal processing unit 100 to correct for these errors during normal receiver operations as shown in step 206. Thereafter, the signal generator 120 is turned off and the amplifier 40 reconnected by the switch 24 to the antenna 20 in accordance with step 208 so as to allow the receiver 20 to return to its normal operational mode. As illustrated in step 210, the receiver 20 may be recalibrated either automatically or by operator command at any time.

The signal generator 120 preferably comprises a comb generator capable of generating narrowband signals at a large number of different frequencies across a wide frequency range. Such a comb generator might include a step recovery or "snap" diode circuit driven by squarewave clock. With, for example, a clock frequency of 10 MHz such a snap diode circuit would generate extremely narrow pulses at 10 MHz intervals across a wide frequency range such as 10 - 200 MHz comprising a "comb" spectrum characterized by 10 MHz of separation between signal frequencies. Calibration signals may thereby be provided in reasonable proximity to the frequencies of the communications signals desired to be received regardless of frequency even in wideband receivers. In operation, the comb line closest to the frequency of a communications signal to be processed by the receiver is used for calibration purposes with the frequency of the injection signals provided to the mixers being tuned to a frequency suitably close to the comb line frequency so as to produce baseband tones comprising specialized baseband components of fixed electrical characteristics suitable for use as test signals in the calibration system of the present invention.

The detection of the errors existing between the I and Q signal channels 30 and 32, respectively (hereafter the "I and Q channels") is accomplished by operation of the digital signal processing unit 100 by simply measuring the difference in the peak-to-peak amplitude of the baseband tones on I and Q channels to determine any hardware gain error, measuring the difference between the positive and negative peak amplitudes of both baseband tones on the I and Q channels to determine any DC offset errors and measuring the phase difference between the baseband tones on the I and Q channels to determine any hardware phase error. The baseband tones are sampled for sufficient time to obtain at least one complete cycle of their values covering both the positive and negative peaks and zero crossing points of the baseband tones on both the I and Q channels. Nevertheless, the sampling procedure is fairly rapid taking about 400 microseconds so that for signals such as analog voice the calibration function can be performed over a period of short enough duration so as to not significantly interfere with information flow.

It should be noted that the sequence in which correction operations are performed is important. First, gain corrections should be performed so as to balance peak-to-peak amplitudes between the two signal channels. Both the I and Q channels should then be adjusted to correct for DC offsets so as to zero the average voltage level on each channel. After both gain and DC offset errors have been compensated, phase error can be accurately measured and appropriate corrections implemented so that the channels ate precisely 90° out-of-phase with one another.

Since the calibration signals are not synchronous with the sampling rate, the peak voltages for the baseband tone waveforms will generally occur between a pair of adjacent samples and will be somewhat larger than the larger of these samples (provided that sufficient resolution is provided by the ADCs 90 and 92). The zero voltage crossing-points which are used to determine phase difference will, in general, also occur between samples at an intermediate "sampling" point between a pair of adjacent samples. Since precise voltage peak and zero crossing readings are required for calculating gain and DC offset errors in the first case and phase errors in the second, corrections should be made to the actual measurements to reflect the limitations of the sampling process.

In order to calculate the voltage peaks to the resolution of a 12 bit ADC with an 83 1/3 KHz sampling rate given 5 volt peak-to-peak 2500 Hz baseband tones, Table I below gives the number in least significant bits ("LSBs") for the ADCs 90 and 92 that must be added to the largest sample to obtain the actual voltage peak by interpolation as a'function of the difference between the two largest samples between which the actual peak is "bracketed".

TABLE I

| DIFFERENCE BETWEEN TWO LARGEST SAMPLES (IN LSBs) | DIFFERENCE BETWEEN LARGEST SAMPLE AND ACTUAL PEAK (IN LSBs) |
|---|---|
| 0 | 8 |
| 1-2 | 7 |
| 3-4 | 6 |
| 5-6 | 5 |
| 7-9 | 4 |
| 10-12 | 3 |
| 13-16 | 2 |
| 17-22 | 1 |
| >22 | 0 |

It should be noted that if the peak-to-peak voltage is not equal to 3412 LSBs (corresponding to 5 volts peak-to-peak with a full scale of 6 volts peak-to-peak for a 12 bit ADC) the numbers used in contunction with Table I must be scaled accordingly.

Linear interpolation between samples may be used to determine the actual zero voltage crossing points since for the relatively small angles and second order effects involved the error in this technique is negligible. Assuming a first sample is below a zero voltage point and a second sample is above a zero voltage point, the actual crossing point may be determined in accordance with interpolation techniques by taking a ratio of the absolute value of voltage level at the first sampling point to the sum of the absolute values of the voltage levels for the first sampling point and second sampling point. The "I/Q amplitude" ratio so determined may be added to the number of sampling taken as of the first sample point to provide a measure of phase referenced to sampling location which provides a benchmark fixed in accordance with the calibration operation. Phase differences can then be calculated based on differences in sampling locations (and fractions thereof) corresponding to reference points on the waveforms of the baseband tones. The phase difference numbers so determined can be multiplied by the known phase difference between samples as a function of the frequency of the baseband tones and the sampling rate to give a measure of phase difference in standard units.

The following example may usefully illustrate the processes involved in calculating actual voltage peaks, actual zero voltage crossing points, gain error, offset error, phase error and determining the appropriate cor-

5

rections based on these calculations. Given the receiver 20 with 12 bit ADCs 90 and 92, 2500 Hz baseband tones and a 83 1/3 KHz sampling rate for the ADCs 90 and 92 and 34 samples taken in a single calibration operation sufficient to cover one cycle of the 2500 Hz baseband tones, assume for purposes of example the largest samples obtained are as follows:

```
Most positive I samples: + 1360, + 1363
Most negative I samples: - 1351, - 1355    (in LSBs)
Most positive Q samples: + 1280, + 1282
Most negative Q samples: - 1288, - 1294
```

The peak-to-peak amplitude of the I channel is 1363 + 1355 = 2718 LSBs. Since Table I is designed for a peak-to-peak amplitude of 3412 LSBs, the difference between the two most positive I samples 1363 - 1360 = 3 LSBs must be scaled by multiplying the same by the ratio of these peak-to-peak amplitudes 3412/2718 = 1.26. Scaling therefore gives a number for the difference between largest samples of 3 X 1.26 = 4 LSBs which results in a peak correction of 6 in accordance with Table I. However, this peak correction must be rescaled to the actual levels measured by multiplication by the "reverse" peak-to-peak amplitude ratio 2718/3412 = .80 which gives 6 X .80 = 5 LSBs. The actual positive peak is therefore equal to 1363 + 5 = 1368 LSBs. Using the same method to calculate the other peak voltages gives the following results:

```
Most Positive I Peak: +1368
Most Negative I Peak: -1359    (in LSBs)
Most Positive Q Peak: +1287
Most Negative Q Peak: -1297
```

The required adjustment for gain errors between the I and Q signal channels which must be applied to the Q (non-reference) channel baseband component is simply a matter of taking a ratio of the sums of the absolute values of the I and Q channel peaks, that is, for the current example (1368 + 1359)/(1287 + 1297) = 1.0553. The Q channel peaks are then multiplied by this ratio to adjust for gain errors between the signal channels (with this adjustment also being automatically implemented during normal signal processing by the digital signal processor 100) with the results being as follows:

```
Positive I Peak: +1368
Negative I Peak: -1359    (in LSBs)
Positive Q Peak: +1358
Negative Q Peak: -1369
```

Based on this information the DC offsets between the signal channels may be accurately determined by calculating one-half of the difference between the absolute values of the voltage peaks. In the present example, this number equals (1368 - 1359)/2 = +5 LSBs for the I channel and (1358 - 1369)/2 = -5 LSBs for the Q channel. The I and Q channel peaks are separately adjusted by these amounts (with this adjustment also being automatically implemented during normal signal processing by the digital signal processing unit 100) with the results being as follows:

```
Positive I Peak: +1363
Negative I Peak: -1364    (in LSBs)
Positive Q Peak: +1363
Negative Q Peak: -1364
```

Phase error may be calculated by comparing the sample point locations of the fixed reference points such as zero , voltage crossing points on the waveforms of the baseband tones. Assume, for the purposes of our example, a positive slope crossing point for the I channel occurring between Samples 8 and 9 and a positive slope crossing point for the Q channel occutring between samples 16 and 17 having values as follows:

```
Sample 8  = -95
Sample 9  = +161        (in LSBs)
Sample 16 = -22
Sample 17 = 220
```

These values must be corrected for gain and DC offset errors by subtracting 5 LCBs from Samples 8 and 9 and by multiplying Samples 16 and 17 by the previously determined I/Q amplitude ratio of 1.0553 and adding 5 LCBs to the result. The corrected values of the samples would then be as follows:

```
Sample  8 = -100
Sample  9 =  156        (in LCBs)
Sample 16 =  -18
Sample 17 =  237
```

It should be noted that the offset correction may occasionally cause a pair of samples to assume the same polarity and accordingly the samples be on the same side of a zero voltage crossing point in which case the samples under consideration must be changed and the correction procedure repeated until the samples have opposite polarities. More specifically, the sample numbers should by alternately incremented and decremented by increasing integer values (i.e. 1,2,3...) until samples "bracketing" the zero voltage crossing point are discovered.

Once the zero voltage crossings are located and corrected for gain and DC offset errors, the actual zero crossing points can now be determined by linear interpolation between the samples. The I channel zero crossing is at sample 8 + (100/(100 + 156) = 8.391 sampling points. The Q channel zero crossing is at sample 16 + (237/(18 + 237) = 16.929 sampling points. The difference between zero crossings locations is 6.929 - 8.391 = 8.538 sampling points. Since the baseband tones maintain a frequency of 2500 Hz while the sample rate is fixed at 83 1/3 KHz, the angular separation between the sampling points is (2500/83,333) X 360° = 10.8°. 8.538 samples therefore represents 10.8 X 8.538 = 92.21° of phase difference between the I and Q channels which equates to a phase error of 92.21° - 90.00° = 2.21° (for signal channels which should be exactly in quadrature or preciously 90° out-of-phase).

The baseband component on the Q channel can be adjusted to correct for this phase error by ratably combining it with a portion of the baseband component on the I channel in accordance with the amount of phase error (although this procedure may introduce a slight gain error). The desired phase shifted value of the baseband component on the Q channel which may be designated as Q′ may be given by Formula 1 below:

$$Q' = (Q/\cos\phi) + (I\tan\phi) \qquad \text{(Formula 1)}$$
where:
$$I = \cos\omega t$$
$$Q = \cos(\omega t - 90° - \phi)$$
$$\phi = \text{phase error}$$

For our example, given a phase error of 2.21°, $Q' = Q/(.993) + I(0.0386)$ with $\cos\phi = .993$ being the "Q phase correction factor" and $\tan\phi = 0.0386$ being the "I phase correction factor"..

The complete formulas for implementing gain, DC offset and phase error corrections are as shown in Formulas 2 and 3 below:

$$I' = I + k_1 \qquad \text{(Formula 2)}$$
$$Q' = k_2 Q + k_3 I + k_4 \qquad \text{(Formula 3)}$$

where:

$k_1$ = I channel offset correction (-5)
$k_4$ = Q channel offset correction (+5)
$k_2$ = ratio of gain correction and phase correction factors
      (1.0553/0.993 = 1.0568)
$k_3$ = I phase correction factor (0.0386)

The values provided above in parentheses for the correction factors $k_1$-$k_4$ represent the appropriate valves from the example previously given.

The previous discussion has shown calculation of correction constant for 2500 Hz baseband tones if a sampling rate of 83 1/3 KHz is used, however, the procedure would be different if the frequency of the baseband tones was selected to be less than 642 Hz. In such sate the largest sample obtained could be assumed to be the peak voltage since 12 bit ADCs would not be capable of providing further resolution. The use of low frequency baseband tones can therefore simplify the calculation of the gain, DC offset and phase errors, however, such low frequency tones also require a much longer sampling period to assure that all required positive and negative peaks and zero voltage crossing point are covered in the sampling operation. Nevertheless, where such a longer sampling period is tolerable with respect to information flow requirements through the receiver, it may be an advantage to operate the calibration system at such low baseband tone frequencies.

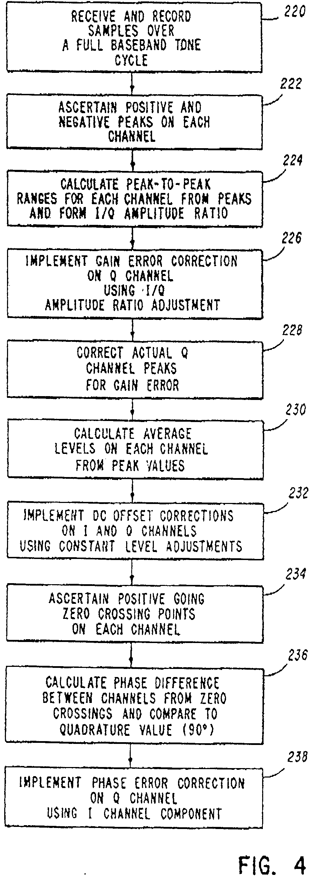

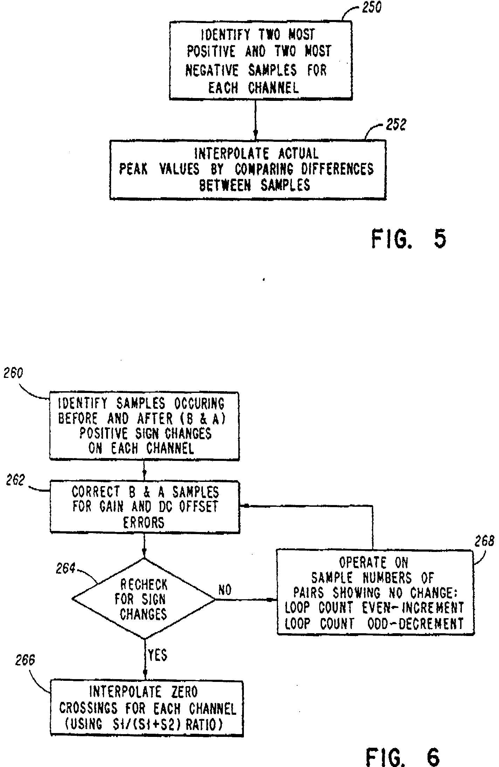

Referring now to Figure 5, 6 and 7, the operation of the calibration algorithms executed by the signal processing unit 100 at the direction of the control unit 110 when in calibration procedures are illustrated in the form of flow charts which provide a summary of the major steps in the routines comprising these algorithms. The routine shown in Figure 4 corresponds to step 204 of Figure 3 while the routines shown in Figure 5 and 6 correspond to step 222 and 234, respectively, in Figure 4.

Referring now to Figure 4, in the first step 220, digital samples of the voltage levels of the baseband tones on the I and Q channels over a full tone cycle, (e.g. 34 samples) are received and recorded in temporary memory location of the signal processing unit 100. After these samples are obtained, the positive and negative voltage peaks on both the I and Q channels are ascertained in accordance with step 222 as further expanded upon in Figure 5. Referring now to Figure 5, the two most positive and two most negative samples first are identified for both the I and Q channels as indicated in step 250. Thereafter, the differences between the values of each pair of samples are calculated and these differences are used to determine the actual peak values by interpolation thru the use of a look-up table (such as Table I) cross referencing the difference values to correction values to be added to the largest samples as per step 252.

Referring now again back to Figure 4, in step 224 the ranges from positive peak to negative peak for each channel are then calculated from the values of the actual peaks determined in the step 222 and an I/Q amplitude ratio is formed which is characteristic of the gain error between the channels. Pursuant to step 226, the gain error correction may be then implemented by providing for the I/Q amplitude ratio to be automatically applied to the baseband component samples for the Q channel. Preliminary to determining DC offset corrections, the actual Q channel peaks are corrected for gain error using the I/Q amplitude ratio in accordance with step 228. The average voltage on each channel may then be calculated from the actual peak values as indicated in step 230. Thereafter, in step 232, DC offset corrections on both the I and Q channels may be implemented by providing for constant level adjustments in accordance with the average levels on each channel to be automatically applied to the baseband components for both the I and Q channels.

Having now detected and implemented corrections with respect to gain and DC offset errors, phase errors may be dealt with by first ascertaining the position of comparable (i.e. temporally sequential) positive going-zero crossing points on each channel with reference to sampling point locations in accordance with step 234 as further expanded upon in Figure 6. Referring now to Figure 6, in step 260 pairs of samples occurring immediately before and after similar changes in voltage polarity are identified on each of the signal channels. As indicated in step 262, these samples are then corrected for gain and DC offset errors using the I/Q amplitude ratio and constant level adjustments previously referred to. However, pursuant to step 264 the samples must then be checked to verify that the samples making up each pair still maintain different polarities. If either one or both of the pairs of samples now longer have different polarities, new pairs of samples must be identified, as shown in step 268, by either incrementing or decrementing the sample numbers of the sample pair or pairs which show no change in polarity. Thereafter, the samples can be processed in accordance with step 262 and again checked pursuant to step 264. If both pairs of samples feature polarity differences, the actual zero crossing points for each channel may be determined by interpolation using the ratio of the voltage level of the first sample to the sum of the voltage levels of the first and second samples to give a fraction indicative of the exact location between samples at which the zero crossing occurs in accordance with step 266.

Referring back again to Figure 4, as indicated in step 236 the phase difference between the channels may be then calculated from the sampling locations of the zero crossing points and compared to the precise quadrature value to determine the actual phase error. Pursuant to step 238, a phase error correction may then be implemented on the Q channel by providing for a small portion of the I channel component to be automatically applied to the Q channel component in accordance with the amount of phase error.

While particular embodiments of the present invention have been shown and described, it should be clear that changes and modifications may be made to such embodiments without departing from the true scope and spirit of the invention. It is intended that the appended claims cover all such changes and modifications.

**Claims**

1.  In a direct conversion receiver having a plurality of signal channels including separate mixers at which components of incoming communications signals are combined with on frequency injection signals to produce out-of-phase baseband components which are then independently processed on said signal channels, a method of correcting for hardware-induced errors in said baseband components, comprising the steps of:
    generating a calibration signal having a frequency in proximity to the frequency of one or more communications signals intended to be processed by said receiver;
    supplying said calibration signal as an input to said receiver on a discontinuous basis in place of a communications signal;
    tuning said injection signals to a suitable frequency for providing baseband tones on said signal channels;
    calculating the phase difference between said baseband tones on said signal channels; and
    adjusting the characteristics of one or more of said signal channels so that said baseband components maintain a predetermined phase relationship.

2.  The method of Claim 1, wherein said step of calculating phase difference includes the substeps of identifying zero voltage crossing points for said baseband tones and determining the phase difference based on said crossing points.

3.  The method of Claim 1, wherein said receiver has a pair of (I and Q) signal channels and said predetermined phase relationship referred to in said step of correcting baseband components comprises a quadrature (90° out-of-phase) relationship.

4.  The method of Claim 4, further including the steps of:
    calculating the gain (amplitude) difference between each of said baseband tones; and
    adjusting the characteristics of one or more of said signal channels so that said components have a predetermined gain relationship.

5.  The method of Claim 4, wherein said step of calculating gain includes the substep of measuring and comparing the peak-to-peak voltage levels of said baseband tones.

6.  The method of Claim 1, further including the steps of:
    calculating the DC offsets of said baseband tones; and
    adjusting the characteristics of one or more of said signal channels so that said baseband tones have zero DC offsets.

7.  The method of Claim 6, wherein said step of calculating DC offsets includes the substep of measuring and summing peak positive and peak negative voltage levels of said baseband tones.

8.  In a direct conversion receiver including a pair of mixers at which components of communications signals are combined with on frequency injection signals to produce but-of-phase baseband components and having a pair of (I and Q) signal channels for independently processing said baseband components, the improvement comprising:
    signal generator means for providing a calibration signal having a frequency in proximity to the frequency of one or more communications signals intended to be processed by said receiver and supplying said calibration signal as an input to said receiver in place of a communications signal;
    control means for supplying said calibration signal as an input to said receiver of a discontinuous basis and for tuning said injection signals to a suitable frequency for providing baseband tones on said signal channels; and
    signal processing means for:
    (a) calculating the phase difference between the baseband tones on said signal channels, and
    (b) adjusting one (Q) of said signal channels so that said components maintain a predetermined phase relationship.

9.  The improvement of Claim 8, wherein said signal processing means performs said function of calculating phase difference by identifying fixed reference points on the waveforms of each of said baseband tones and determining the phase difference between them.

10. The improvement of Claim 9, wherein said fixed reference points comprise zero voltage crossing points.

11. The improvement of Claim 8, wherein said signal processing means further performs the functions of:
(c) calculating the gain (amplitude) difference between each of said baseband tones,
(d) adjusting one (Q) of said signal channels so that said components have a predetermined gain relationship.

12. The improvement of Claim 11, wherein said function of calculating gain is performed by measuring and comparing the peak-to-peak voltage levels of said baseband tones.

13. The improvement of Claim 8, wherein said signal processing means further performs the functions of:
(c) calculating the DC offsets of said baseband tones and
(d) adjusting said signal channels'so that said baseband components have zero DC offsets.

14. The improvement of Claim 13, wherein said function of calculating DC offsets is performed by measuring and summing peak positive and peak negative voltages for said baseband tones.

15. The improvement of Claim 8, wherein said signal generator means comprises a comb generator for providing a set of narrow band calibration signals spaced-apart across a wide frequency range.

16. In a wideband direct conversion receiver including a RF coupler for splitting a RF communication signal into RF components, first and second (I and Q) baseband signal channels having separate mixers, filters and amplifier units which are operative for processing said components, synthesizer means for generating injection signals on frequency with said communications signal for supply to the mixers associated with the signal channels and a signal processing unit for demodulating said communications signal based on its baseband components, the improvement comprising:
a comb signal generator for providing a set of narrow-band calibration signals spaced-apart across a wide Frequency range;
control means for:
identifying a calibration signal in proximity to one or more communications signals to be processed by said receiver,
supplying said calibration signal to said receiver on a discontinuous basis, and
tuning said injection signal to a suitable frequency for providing baseband tones on said signal channels;
signal channels processing means for:
(a) calculating the phase difference between the baseband tones on said signal channels, and
(b) adjusting one (Q) signal channels so that said , components maintain a predetermined phase relationship.

17. The improvement of Claim 16, wherein said signal processing means performs said function of calculating phase difference by identifying fixed reference points of the waveforms of each of said baseband tones and determining the phase difference between them.

18. The improvement of Claim 17, wherein said fixed reference points comprise zero voltage crossing points.

19. The improvement of Claim 16, wherein said signal processing means further performs the functions of:
(c) calculating the gain (amplitude) difference between each of said baseband tones,
(d) adjusting one (Q) of said signal channels so that said components have a predetermined gain relationship.

20. The improvement of Claim 11, wherein said function of calculating gain is performed be measuring and comparing the peak-to-peak voltage levels of said baseband tones.

21. The improvement of Claim 16, wherein said signal processing means further performs the functions of:
(c) calculating the DC offsets of said baseband tones, and
(d) adjusting said signal channels so that said baseband components have zero DC offsets.

**22.** The improvement of Claim 21, wherein said function of calculating DC offsets is performed by measuring and summing peak positive and peak negative voltages for said baseband tones.

**23.** In a direct conversion receiver having a plurality of signal channels includind separate mixers at which components of incoming communications signals are combined with on frequency injection signals to produce out-of-phase baseband components which are then independently processed on said signal channels, a method of calibrating said signal channels to correct for hardware-induced errors comprising the steps of:

generating a calibration signal having a frequency in proximity to the frequency of one or more communications signals intended to be processed by said receiver;

supplying said calibration signal as an input to said receiver for a short interval of insufficient duration to significantly interfere with the information flow associated with said communication signals;

tuning said injection signals to a suitable frequency for providing baseband tones on said signal channels; and

digitally processing said baseband tones by:

(a) sampling said baseband tones over a short interval of insufficient duration to significantly interfere with the information flow associated with said communications signals,

(b) ascertaining the phase relationship between said baseband tones, and

(c) adjusting the characteristics of one (Q) of said signals channels so that said baseband components have a predetermined phase relationship.

**24.** The method of Claim 23, wherein said step of calculating phase difference includes the substeps of identifying zero voltage crossing points for said baseband tones and determining the phase difference based on said crossing points.

**25.** The method of Claim 23, wherein said digital processing step further includes the steps of:

calculating the gain (amplitude) difference between each of said baseband tones; and

adjusting the characteristics of one or more of said signal channels so that said components have a predetermined gain relationship.

**26.** The method of Claim 25, wherein said step of calculating gain includes the substep of measuring and comparing the peak-to-peak voltage levels of said baseband tones.

**27.** The method of Claim 23, wherein said digital processing step, further includes the steps of:

calculating the DC offsets of said baseband tones; and

adjusting the characteristics of one or more of said signal channels so that said baseband tones have zero DC offsets.

**28.** The method of Claim 27, wherein said step of calculating DC offsets includes the substep of measuring and summing peak positive and peak negative voltage levels of said baseband tones.

**29.** A method for determining the hardware-induced phase error existent between the baseband components on the signal channels of am I/Q channel direct conversion receiver, comprising the steps of:

digitizing the baseband components produced by said signal channels over a sufficient period to cover comparable zero voltage crossing points on each channel;

identifying the positions of comparable zero voltage crossing points on each of said channels by reference to their sampling point locations;

calculating the phase difference between components based on said sampling point locations of said zero voltage crossing points; and

comparing said phase difference to the desired in quadrature (90°) value to determine the phase error between the signal channels.

**30.** The method of Claim 29, wherein said step of identifying the positions of comparable zero voltage crossing points includes the substeps of identifying the samples adjacent to said zero voltage crossing points and calculating the position of the exact sampling point locations of the zero voltage crossing points by interpolation.

**31.** The method of Claim 29, wherein said step of digitizing is performed by sample and hold circuits operating in combination with analog-to-digital convertors.

32. A method for determining the hardware-induced gain error existent between the baseband components on the signal channels of an I/Q channel direct conversion receiver, comprising the steps of:

Digitizing the baseband components produced by said signal channels over a sufficient period to cover positive and negative peaks on each channel;

identifying samples adjacent to negative and positive voltage peaks on each of said signal channels;

calculating the peak-to-peak voltage ranges on said signal channels based on said samples adjacent to said peaks; and

determining said gain error between said signal channels by comparing said peak-to-peak ranges.

33. The method of Claim 32, wherein said step of calculating peak-to-peak voltage ranges includes the substep of estimating actual voltage peaks based on said samples adjacent to said peaks by interpolation.

34. The method of Claim 33, wherein said substep of estimating by interpolation includes the substep of referencing a look-up table including values which are a function of differences between adjacent,sample values.

35. The method of Claim 32, wherein said step of digitizing is performed by sample and hold circuits operating in combination with analog-to-digital convertors.

EP 0 473 373 A2

FIG. 1
PRIOR ART

FIG. 2

200 ── ENTER
CALIBRATION MODE

202 ── DISCONNECT ANTENNA
INPUT AND TURN ON SIGNAL
GENERATOR

204 ── TUNE INJECTION
SIGNAL TO PRODUCE
BASEBAND TONES

206 ── DETECT GAIN, DC
OFFSET AND PHASE
ERRORS AND IMPLEMENT
CORRECTIONS

208 ── SWITCH OFF SIGNAL
GENERATOR AND
RECONNECT ANTENNA

210 ── REENTER
CALIBRATION MODE
(RECALIBRATE ON
FREQUENCY CHANGES, ETC.)

FIG. 3

```
                    ┌──────────────────────┐  ╭ 220
                    │   RECEIVE AND RECORD  │
                    │     SAMPLES OVER      │
                    │  A FULL BASEBAND TONE │
                    │        CYCLE          │
                    └──────────┬───────────┘
                               │              ╭ 222
                    ┌──────────▼───────────┐
                    │  ASCERTAIN POSITIVE AND │
                    │   NEGATIVE PEAKS ON EACH │
                    │         CHANNEL        │
                    └──────────┬───────────┘
                               │              ╭ 224
                    ┌──────────▼───────────┐
                    │   CALCULATE PEAK-TO-PEAK │
                    │ RANGES FOR EACH CHANNEL FROM PEAKS │
                    │  AND FORM I/Q AMPLITUDE RATIO │
                    └──────────┬───────────┘
                               │              ╭ 226
                    ┌──────────▼───────────┐
                    │ IMPLEMENT GAIN ERROR CORRECTION │
                    │        ON Q CHANNEL      │
                    │         USING ·I/Q       │
                    │   AMPLITUDE RATIO ADJUSTMENT │
                    └──────────┬───────────┘
                               │              ╭ 228
                    ┌──────────▼───────────┐
                    │     CORRECT ACTUAL Q    │
                    │      CHANNEL PEAKS      │
                    │       FOR GAIN ERROR    │
                    └──────────┬───────────┘
                               │              ╭ 230
                    ┌──────────▼───────────┐
                    │    CALCULATE AVERAGE    │
                    │  LEVELS ON EACH CHANNEL │
                    │     FROM PEAK VALUES    │
                    └──────────┬───────────┘
                               │              ╭ 232
                    ┌──────────▼───────────┐
                    │ IMPLEMENT DC OFFSET CORRECTIONS │
                    │     ON I AND Q CHANNELS  │
                    │ USING CONSTANT LEVEL ADJUSTMENTS │
                    └──────────┬───────────┘
                               │              ╭ 234
                    ┌──────────▼───────────┐
                    │   ASCERTAIN POSITIVE GOING │
                    │     ZERO CROSSING POINTS │
                    │       ON EACH CHANNEL   │
                    └──────────┬───────────┘
                               │              ╭ 236
                    ┌──────────▼───────────┐
                    │  CALCULATE PHASE DIFFERENCE │
                    │ BETWEEN CHANNELS FROM ZERO │
                    │  CROSSINGS AND COMPARE TO │
                    │   QUADRATURE VALUE (90°) │
                    └──────────┬───────────┘
                               │              ╭ 238
                    ┌──────────▼───────────┐
                    │ IMPLEMENT PHASE ERROR CORRECTION │
                    │        ON Q CHANNEL      │
                    │  USING I CHANNEL COMPONENT │
                    └──────────────────────┘
```

FIG. 4

*250*

IDENTIFY TWO MOST
POSITIVE AND TWO MOST
NEGATIVE SAMPLES FOR
EACH CHANNEL

*252*

INTERPOLATE ACTUAL
PEAK VALUES BY COMPARING DIFFERENCES
BETWEEN SAMPLES

## FIG. 5

*260*

IDENTIFY SAMPLES OCCURING
BEFORE AND AFTER (B & A)
POSITIVE SIGN CHANGES
ON EACH CHANNEL

*262*

CORRECT B & A SAMPLES
FOR GAIN AND DC OFFSET
ERRORS

*264*

RECHECK
FOR SIGN
CHANGES

NO

*268*

OPERATE ON
SAMPLE NUMBERS OF
PAIRS SHOWING NO CHANGE:
LOOP COUNT EVEN-INCREMENT
LOOP COUNT ODD-DECREMENT

YES

*266*

INTERPOLATE ZERO
CROSSINGS FOR EACH CHANNEL
(USING S1/(S1+S2) RATIO)

## FIG. 6

16